# EUROPEAN PATENT SPECIFICATION

(11) **EP 1 684 118 B1**
(45) Date of publication and mention of the grant of the patent: **18.04.2012**
(21) Application number: 06250056.6
(22) Date of filing: 06.01.2006
(51) Int. Cl.: G03F 7/038, C08L 25/18

(54) **Patterning process using a negative resist composition**
Mustererungsverfahren mit einer Negativresistzusammensetzung
Procédé d'élaboration de motifs utilisant une composition de réserve négative

(30) Priority: 21.01.2005 JP 2005013585
(43) Date of publication of application: 26.07.2006
(73) Proprietor: Shin-Etsu Chemical Co., Ltd., Tokyo (JP)
(72) Inventor: Koitabashi,Ryuji c/o New Functional Materials R.C., Kubiki-ku, Joetsu-shi, Niigata-ken (JP); Watanabe,Tamotsu c/o New Functional Materials R.C., Kubiki-ku, Joetsu-shi, Niigata-ken (JP); Takeda, Takanobu c/o New Functional Materials R.C., Kubiki-ku, Joetsu-shi, Niigata-ken (JP); Watanabe,Satoshi c/o New Functional Materials R.C., Kubiki-ku, Joetsu-shi, Niigata-ken (JP)
(74) Representative: Stoner, Gerard Patrick

(56) References cited:
- US-A1- 2004 023 151
- US-A1- 2004 033 432
- US-A1- 2004 167 322

## Description

This invention relates to the use of lithographic negative resist compositions useful in the processing of semiconductor or the manufacture of photomasks where both relatively high etching resistance and high resolution are required. More particularly, it relates to a patterning process using a negative resist composition comprising as a base resin a polymer comprising hydroxystyrene units, second units having high etching resistance, and third units for optimized resolution, which composition meets both etching resistance and high resolution.

### BACKGROUND

While a number of efforts are currently being made to achieve a finer pattern in the drive for higher integration in integrated circuits, acid-catalyzed, chemically amplified resist compositions are thought to hold particular promise in the microfabrication technology. The energy sources for exposure include high-energy radiation such as UV, deep-UV and electron beam. For the electron beam lithography which is considered attractive as the micropatterning technique to sizes of 0.1 µm or less, the emphasis is on chemically amplified negative resist compositions having a crosslinker compounded therein with the advantage of precisely sized pattern features (as disclosed in JP-A 5-34922 and JP-A 6-301200), which become essential for mask pattern formation as well.

However, image writing with electron beam takes a long time compared with conventional projection exposure systems. For increased throughputs, higher sensitivity is required. Another crucial requirement is the stability with time in vacuum during or after the image writing. As found with coating films (SiO₂, TiN, Si₃N₃, etc.) on silicon wafers and chromium oxide on mask blanks, some substrates may affect the resist profile following development. Then, for maintaining a high resolution and the profile following etching, it is an important factor to maintain the resist pattern profile rectangular independent of the type of substrate.

The progress of resolution to feature sizes of 0.07 µm or less is concomitant with the formation of a pattern from a thinner film. This situation creates a desire to have a negative resist composition having higher etching resistance.

One research group in Shin-Etsu Chemical Co., Ltd., to which the inventors belong, already disclosed in JP-A-2003/233185 (US-A-2004/0023151) a negative resist composition comprising a hydroxstyrene-indene copolymer. This resist composition provides a higher etching resistance and comparable resolution relative to convention resist compositions. Positive resist compositions including indene units had previously been proposed in JP-A-2002/202610 (EP-A-1204001). In the chemically amplified positive resists of EP-A-1204001 some of the indene and/or styrene units carry acid labile groups, such as C₄₋₂₀ alkoxy, C₄₋₂₀ oxoalkoxy, alkoxyalkoxy, C₄₋₄₀ alkoxycarbonyloxy and C₄₋₄₀ alkoxycarbonylalkyloxy groups. These acid labile groups are selected to be readily catalytically released by acid from the photoacid generator of the chemically amplified positive resist composition, according to the mechanism of a positive resist.

Our US2004/00333432A1, US2004/0166432A1 and US2004/0167322A1 propose various photoacid generators based on sulfonyldiazomethane compounds, for use in chemically amplified resist compositions of either positive or negative type. They are disclosed for use with a generic range of possible alkali-soluble resins, including those based on hydroxystyrene, on combinations of hydroxystyrene with (meth)acrylate, and combinations of hydroxystyrene with (meth)acrylate and/or indene units and others. It is disclosed generally that, across the range of resins, from 0 to 80 mol % of acid labile group-bearing units may be included, and that the molecular weight is e.g. from 3000 to 100000. Suggested acid labile groups include those such as mentioned above for EP-A-1204001. Examples of acid labile groups for positive resists include tert-butoxycarbonyl and other, larger groups. Separately, it is contemplated in general that some phenolic hydroxyl or carboxy groups in a negative photoresist might include suitable substituent groups, especially those stable against acid and alkali (including among others methoxycarbonyl and ethoxycarbonyl) but also the possibly acid-decomposable substituent groups such as t-butoxycarbonyl and relatively acid-undecomposable substituent groups such as t-butyl. The worked examples adopt t-butoxycarbonyl substitution in some positive resist compositions.

Proposed substrates in these documents are Si, SiO₂ SiN, SiON, TiN, WSi, BPSG, SOG and organic anti-reflecting films. Exposure radiation may be UV, deep UV, electron beam, X-ray, excimer laser light, gamma-ray or synchrotron radiation. The examples used silicon wafer substrates and excimer laser radiation.

It is known to apply a negative photoresist onto chromium, such as in US2004/0048423 A1 to define the electrode of a thin film transistor.

Separately, as a means for enhancing the resolution of chemically amplified negative resist compositions, JP-A-11/349760 disclosed the use of a novolac resin or polyhydroxystyrene in which some hydroxyl groups are protected with substituent groups which are not decomposed with acid. Since the reason why resolution is improved is not described in this patent, the range of resins to which that concept is applicable is not well understood.

Our aim herein is to provide new and useful patterning processes using negative resist compositions, to give a high sensitivity, high resolution, age stability and process adaptability, particularly as compared with conventional negative resist compositions, with good or improved etching resistance, and forming a good pattern profile over a range of different substrate types, and particularly onto chromium or chromium compound sputtered films.

The inventor has found that for hydroxystyrene-indene copolymers, not only the substituent groups which are not decomposed with acid, but also substituent groups which are decomposed by reacting with acid, such as tertiary alkyl groups and tertiary alkyloxycarbonyl groups, are effective in achieving significant improvements in resolution.

The invention provides a process for forming a resist pattern, comprising the steps of:
applying a negative resist composition onto a chromium or chromium compound film deposited on a substrate by sputtering, to form a coating,
heat treating the coating and exposing the coating to high-energy radiation,
optionally heat treating the exposed coating, and developing the coating with a developer,
said negative resist composition comprising
a polymer comprising recurring units having the general formula (1): 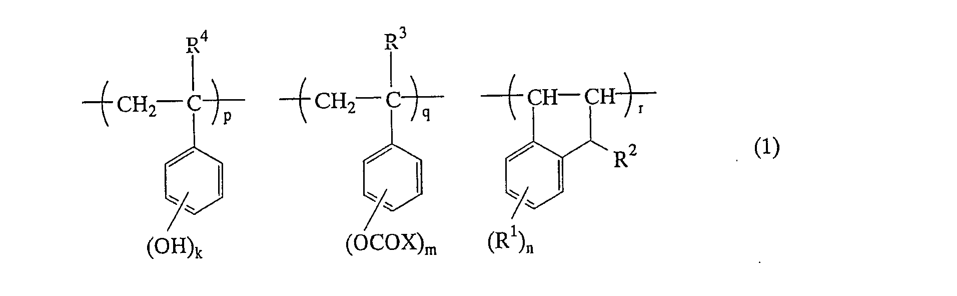 wherein X is a straight or branched alkyl group of 1 to 4 carbon atoms or a straight or branched alkoxy group of 1 to 4 carbon atoms, R¹ and R² are each independently a hydrogen atom, hydroxy group, straight or branched alkyl group, alkoxy group which may be substituted, or halogen atom, R³ and R⁴ are hydrogen or methyl, n is a positive integer of 1 to 4, m and k each are a positive integer of 1 to 5, p, q, r are positive numbers, the polymer having a weight average molecular weight of 1,000 to 500,000,
a photoacid generator capable of generating acid upon exposure to high-energy radiation, and
a crosslinker capable of inducing crosslinkage to the polymer with the aid of the acid generated by the photoacid generator.

As long as the negative resist composition, especially chemically amplified negative resist composition, comprises a polymer comprising recurring units of the general formula (1) and having a weight average molecular weight of 1,000 to 500,000, a photoacid generator capable of generating acid upon exposure to high-energy radiation, and a crosslinker capable of inducing crosslinkage to the polymer with the aid of the acid generated by the photoacid generator, we find that it can exhibit a high sensitivity, high resolution, etching resistance, and age stability when processed by lithography including exposure to high-energy radiation, especially electron beam lithography.

In a preferred embodiment, the polymer comprising recurring units of formula (1) comprises, in admixture, a first polymer having a weight average molecular weight of 2,000 to less than 4,000 and a second polymer having a weight average molecular weight of 4,000 to 20,000. Compounding a mixture of the first and second polymers having different weight average molecular weight enables to establish both a high dissolution rate contrast and a minimal line edge roughness (LER), we find.

In a further preferred embodiment, the negative resist composition is formulated as a chemically amplified negative resist composition by further compounding a basic compound, a surfactant, and an organic solvent. The addition of basic compound may hold down the diffusion rate of acid within the resist film and improve the resolution. The addition of surfactant and organic solvent may enhance or control the ease of coating of the resist composition.

The resist composition exerts its advantages to a full extent when applied onto the metal or metal compound film deposited on a substrate by sputtering, specifically a metal or metal compound film deposited on a quartz substrate as a semi-transmissive or light-shielding film by sputtering, such as a metal or metal compound film deposited on a blank substrate. The metal is chromium. A very high resolution is achievable when electron beam (EB) is used as the high-energy radiation. Of course, the development may be carried out after the exposure (image writing) and heat treatment. The process may further include etching, resist removal, cleaning and other steps.

A polymer comprising recurring units of the general formula (1) is preparable by copolymerizing a substitutable indene, a monomer having alkali solubility or having a structure which is convertible to a functional group having alkali solubility through deblocking reaction or the like, and a monomer having no or little alkali solubility, followed by deblocking, modification or the like. When this polymer is compounded as a base resin, it is possible to formulate a negative resist composition, especially a chemically amplified negative resist composition, which has a high contrast of alkali dissolution rate before and after exposure, high sensitivity, high resolution, and good etching resistance, and is thus suitable as a mask pattern-forming material involving EB image writing.

### FURTHER EXPLANATIONS; OPTIONS AND PREFERENCES

Embodiments of the invention are described below in detail.

### Polymer

We have found that a high molecular weight compound or polymer comprising recurring units of the general formula (1) and having a weight average molecular weight of 1,000 to 500,000 is effective as a base resin in a negative resist composition, especially a chemically amplified negative resist composition; that a negative resist composition, especially a chemically amplified negative resist composition comprising the polymer, a crosslinker, and a photoacid generator exhibits a high dissolution contrast of resist film, high resolution, exposure latitude, and process adaptability, and affords a satisfactory pattern profile after exposure independent of a particular type of substrate, while it has better etching resistance. These advantages combined with the high productivity of the base resin ensure that the resist composition is fully acceptable in commercial application and suited as resist material for VLSI microfabrication. 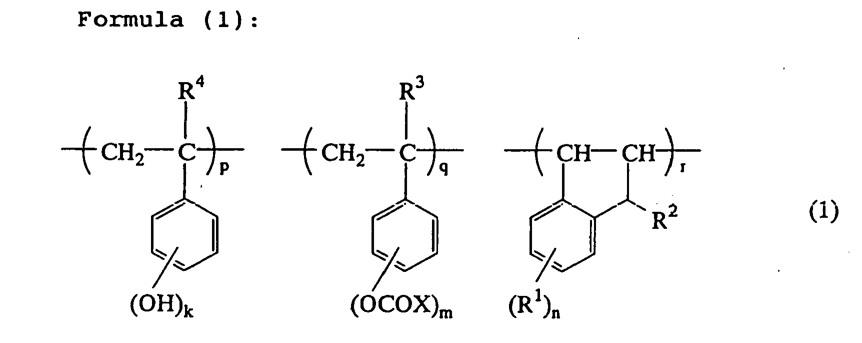 Herein X is a straight or branched alkyl group of 1 to 4 carbon atoms or a straight or branched alkoxy group of 1 to 4 carbon atoms, R¹ and R² are each independently a hydrogen atom, hydroxy group, straight or branched alkyl group, substitutable alkoxy group or halogen atom, R³ and R⁴ each are hydrogen or methyl, n is a positive integer of 1 to 4, m and k each are a positive integer of 1 to 5, p, q and r are positive numbers.

More particularly, X is a substituent group for controlling physical properties of the polymer. An increased chain length for X may adversely affect the adhesion of resist film to the substrate. The preferred alkyl groups are methyl and tert-butyl, and the preferred alkoxy groups are methoxy and tert-butoxy.

For X, the more preferred structures are methyl and tert-butyl groups, from which higher resolution is expectable, although such preference depends on a balance relative to the other units.

When R¹ and R² stand for alkyl groups, they may be straight or branched and are preferably those of 1 to 4 carbon atoms, such as methyl, ethyl, propyl, isopropyl, n-butyl, isobutyl, and tert-butyl. When R¹ and R² stand for halogen atoms, there are included fluorine, chlorine and bromine atoms.

When R¹ and R² stand for alkoxy groups, they include unsubstituted alkoxy groups of 1 to 5 carbon atoms, such as methoxy, ethoxy, propoxy, n-butoxy, isobutoxy, and tert-butoxy. Also included are substituted alkoxy groups e.g. in which one or more of hydrogen atoms on the alkyl moiety of alkoxy groups as proposed above are replaced by epoxy groups, hydroxy groups, halogen atoms or the like, as shown e.g. by general formulae (2) and (3).

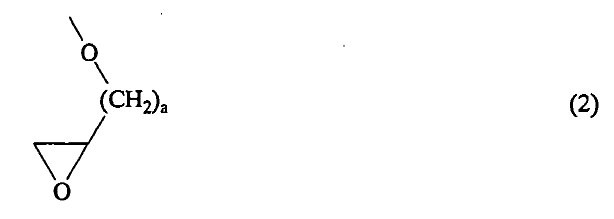

In formula (2), a is an integer of 0 to 5.

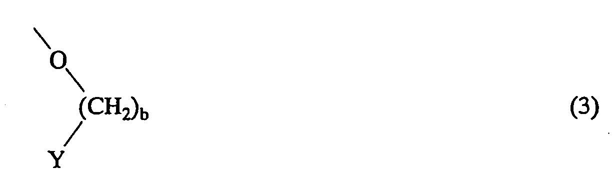

In formula (3), Y is a hydroxy group or a fluorine, chlorine or bromine atom, and b is an integer of 1 to 3.

A typical example of formula (2) is a glycidyloxy group. Illustrative examples of formula (3) include hydroxymethyloxy, chloromethyloxy and bromomethyloxy groups.

In formula (1), p, q and r are positive numbers, and should preferably meet the following relationship, when properties of the resist composition are taken into account. That is, p, q and r should preferably meet: 0 < r/(p+q+r) s 0.3, more preferably 0.05 < r/(p+q+r) ≤ 0.25, and 0 < q/(p+q+r) s 0.15.

In formula (1), n, m and k are as defined above, and most often independently 1 or 2.

It is understood that these polymers may be compounded alone or in admixture of two or more or in a blend with other resin of the same or different type.

The polymers to be compounded in the composition should have a weight average molecular weight (Mw) of 1,000 to 500,000, preferably 2,000 to 10,000, as measured by gel permeation chromatography (GPC) versus polystyrene standards. With too low a Mw, the resist composition may become less heat resistant. Too high a Mw adversely affects the alkali dissolution and increases a tendency for a footing phenomenon to occur after pattern formation.

A higher contrast and better pattern profile are obtainable when the polymer to be compounded as the base resin is a mixture of a first polymer (P1) having a weight average molecular weight of 2,000 to less than 4,000 and a second polymer (P2) having a weight average molecular weight of 4,000 to 20,000, more preferably 4,000 to 8,000. With respect to the proportion of polymers P1 and P2 added, the weight ratio of P1:P2 is preferably in a range from 1:0.1 to 1:2, more preferably from 1:0.5 to 1:1.5.

When the aforementioned polymer is compounded as a base resin and combined with a crosslinker and a photoacid generator, a chemically amplified negative resist composition is formulated, which possesses a high dissolution contrast of resist film before and after exposure, high sensitivity, high resolution and age stability, and exhibits better etching resistance, and is thus very effective as a negative resist material, particularly in the electron beam lithography.

### Photoacid generator

The photoacid generator which is compounded in the negative resist composition may be any of compounds which generate acid upon exposure to high-energy radiation. Suitable photoacid generators include sulfonium salts, iodonium salts, sulfonyldiazomethane and N-sulfonyloxyimide photoacid generators. Exemplary photoacid generators are given below while they may be used alone or in admixture of two or more.

Sulfonium salts are salts of sulfonium cations with sulfonate anions. Exemplary sulfonium cations include triphenylsulfonium, (4-tert-butoxyphenyl)diphenylsulfonium, bis(4-tert-butoxyphenyl)phenylsulfonium, tris(4-tert-butoxyphenyl)sulfonium, (3-tert-butoxyphenyl)diphenylsulfonium, bis(3-tert-butoxyphenyl)phenylsulfonium, tris(3-tert-butoxyphenyl)sulfonium, (3,4-di-tert-butoxyphenyl)diphenylsulfonium, bis(3,4-di-tert-butoxyphenyl)phenylsulfonium, tris(3,4-di-tert-butoxyphenyl)sulfonium, diphenyl(4-thiophenoxyphenyl)sulfonium, (4-tert-butoxycarbonylmethyloxyphenyl)diphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, dimethyl-2-naphthylsulfonium, 4-hydroxyphenyldimethylsulfonium, 4-methoxyphenyldimethylsulfonium, trimethylsulfonium, 2-oxocyclohexylcyclohexylmethylsulfonium, trinaphthylsulfonium, and tribenzylsulfonium. Exemplary sulfonate anions include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, and methanesulfonate. Sulfonium salts based on combination of the foregoing examples are included.

Iodinium salts are salts of iodonium cations with sulfonate anions. Exemplary iodonium cations are aryliodonium cations including diphenyliodinium, bis(4-tert-butylphenyl)iodonium, 4-tert-butoxyphenylphenyliodonium, and 4-methoxyphenylphenyliodonium. Exemplary sulfonate anions include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, and methanesulfonate. Iodonium salts based on combination of the foregoing examples are included.

Exemplary sulfonyldiazomethane compounds include bissulfonyldiazomethane compounds and sulfonyl-carbonyldiazomethane compounds such as bis(ethylsulfonyl)diazomethane, bis(1-methylpropylsulfonyl)diazomethane, bis(2-methylpropylsulfonyl)diazomethane, bis(1,1-dimethylethylsulfonyl)diazomethane, bis(cyclohexylsulfonyl)diazomethane, bis(perfluoroisopropylsulfonyl)diazomethane, bis(phenylsulfonyl)diazomethane, bis(4-methylphenylsulfonyl)diazomethane, bis(2,4-dimethylphenylsulfonyl)diazomethane, bis(2-naphthylsulfonyl)diazomethane, 4-methylphenylsulfonylbenzoyldiazomethane, tert-butylcarbonyl-4-methylphenylsulfonyldiazomethane, 2-naphthylsulfonylbenzoyldiazomethane, 4-methylphenylsulfonyl-2-naphthoyldiazomethane, methylsulfonylbenzoyldiazomethane, and tert-butoxycarbonyl-4-methylphenylsulfonyldiazomethane.

N-sulfonyloxyimide photoacid generators include combinations of imide skeletons with sulfonate skeletons. Exemplary imide skeletons are succinimide, naphthalene dicarboxylic acid imide, phthalimide, cyclohexyldicarboxylic acid imide, 5-norbornene-2,3-dicarboxylic acid imide, and 7-oxabicyclo[2.2.1]-5-heptene-2,3-dicarboxylic acid imide. Exemplary sulfonate skeletons include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate.

Additionally, other photoacid generators as listed below are useful. Benzoinsulfonate photoacid generators include benzoin tosylate, benzoin mesylate, and benzoin butanesulfonate.

Pyrogallol trisulfonate photoacid generators include pyrogallol, fluoroglycine, catechol, resorcinol, hydroquinone, in which all the hydroxyl groups are substituted with sulfonate groups such as trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate.

Nitrobenzyl sulfonate photoacid generators include 2,4-dinitrobenzyl sulfonate, 2-nitrobenzyl sulfonate, and 2,6-dinitrobenzyl sulfonate, with exemplary sulfonates including trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate. Also useful are analogous nitrobenzyl sulfonate compounds in which the nitro group on the benzyl side is substituted with a trifluoromethyl group.

Sulfone photoacid generators include bis(phenylsulfonyl)methane, bis(4-methylphenylsulfonyl)methane, bis(2-naphthylsulfonyl)methane, 2,2-bis(phenylsulfonyl)propane, 2,2-bis(4-methylphenylsulfonyl)propane, 2,2-bis(2-naphthylsulfonyl)propane, 2-methyl-2-(p-toluenesulfonyl)propiophenone, 2-cyclohexylcarbonyl-2-(p-toluenesulfonyl)propane, and 2,4-dimethyl-2-(p-toluenesulfonyl)pentan-3-one.

Photoacid generators in the form of glyoxime derivatives include bis-O-(p-toluenesulfonyl)-α-dimethylglyoxime, bis-O-(p-toluenesulfonyl)-α-diphenylglyoxime, bis-O-(p-toluenesulfonyl)-α-dicyclohexylglyoxime, bis-O-(p-toluenesulfonyl)-2,3-pentanedioneglyoxime, bis-O-(p-toluenesulfonyl)-2-methyl-2,3-pentanedioneglyoxime, bis-O-(n-butanesulfonyl)-α-dimethylglyoxime, bis-O-(n-butanesulfonyl)-α-diphenylglyoxime, bis-O-(n-butanesulfonyl)-α-dicyclohexylglyoxime, bis-O-(n-butanesulfonyl)-2,3-pentanedioneglyoxime, bis-O-(n-butanesulfonyl)-2-methyl-3,4-pentanedioneglyoxime, bis-O-(methanesulfonyl)-α-dimethylglyoxime, bis-O-(trifluoromethanesulfonyl)-α-dimethylglyoxime, bis-O-(1,1,1-trifluoroethanesulfonyl)-α-dimethylglyoxime, bis-O-(tert-butanesulfonyl)-α-dimethylglyoxime, bis-O-(perfluorooctanesulfonyl)-α-dimethylglyoxime, bis-O-(cyclohexylsulfonyl)-α-dimethylglyoxime, bis-O-(benzenesulfonyl)-α-dimethylglyoxime, bis-O-(p-fluorobenzenesulfonyl)-α-dimethylglyoxime, bis-O-(p-tert-butylbenzenesulfonyl)-α-dimethylglyoxime, bis-O-(xylenesulfonyl)-α-dimethylglyoxime, and bis-O-(camphorsulfonyl)-α-dimethylglyoxime.

Of these, sulfonium salt, bissulfonyldiazomethane and N-sulfonyloxyimide photoacid generators are preferred.

While the anion of an optimum photoacid generator varies depending on the type of crosslinker and the reactivity of base resin in the resist composition, it is generally selected from those anions which are nonvolatile and not extremely diffusive. Suitable anions include benzenesulfonate, toluenesulfonate, 4-(4-toluenesulfonyloxy)benzenesulfonate, pentafluorobenzenesulfonate, 2,2,2-trifluoroethanesulfonate, nonafluorobutanesulfonate, heptadecafluorooctanesulfonate, camphorsulfonate, and 2,4,6-triisopropylbenzenesulfonate anions.

In the negative resist composition used herein the photoacid generator is preferably added in an amount of 0.1 to 30 parts by weight, more preferably 1 to 20 parts by weight per 100 parts by weight of the polymer or base resin. The photoacid generators may be used alone or in admixture of two or more. The transmittance of the resist film can be controlled by using a photoacid generator having a low transmittance at the exposure wavelength and adjusting the amount of the photoacid generator added.

### Crosslinker

The crosslinker used herein may be any of crosslinkers which induce intramolecular and intermolecular crosslinkage to the polymer with the aid of the acid generated by the photoacid generator or directly in response to light. Suitable crosslinkers include bisazides, alkoxymethylglycolurils, and alkoxymethylmelamines.

Examples of suitable bisazides include 4,4'-diazidophenyl sulfide, bis(4-azidobenzyl)methane, bis(3-chloro-4-azidobenzyl)methane, bis-4-azidobenzylidene, 2,6-bis(4-azidobenzylidene)-cyclohexanone, and 2,6-bis(4-azidobenzylidene)-4-methylcyclohexanone. Examples of suitable alkoxymethylglycolurils include tetramethoxymethylglycoluril, 1,3-bismethoxymethyl-4,5-bismethoxyethylene urea, and bismethoxymethyl urea. Examples of suitable alkoxymethylmelamines include hexamethoxymethylmelamine and hexaethoxymethylmelamine.

In the negative resist composition used herein the crosslinker is preferably added in an amount of 2 to 40 parts by weight, more preferably 5 to 20 parts by weight per 100 parts by weight of the polymer or base resin. The crosslinkers may be used alone or in admixture of two or more. The transmittance of the resist film can be controlled by using a crosslinker having a low transmittance at the exposure wavelength and adjusting the amount of the crosslinker added.

### Basic compound

In the embodiment using a chemically amplified negative working resist composition, a basic compound may be added to the composition. The basic compound used herein is preferably a compound capable of suppressing the rate of diffusion when the acid generated by the photoacid generator diffuses within the resist film. The inclusion of this type of basic compound holds down the rate of acid diffusion within the resist film, resulting in better resolution. In addition, it suppresses changes in sensitivity following exposure and reduces substrate and environment dependence, as well as improving the exposure latitude and the pattern profile.

Examples of basic compounds include ammonia, primary, secondary, and tertiary aliphatic amines, aromatic amines, heterocyclic amines, nitrogen-containing compounds having carboxyl group, nitrogen-containing compounds having sulfonyl group, nitrogen-containing compounds having hydroxyl group, nitrogen-containing compounds having hydroxyphenyl group, alcoholic nitrogen-containing compounds, amide derivatives, and imide derivatives.

Examples of suitable primary aliphatic amines include methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, tetraethylenepentamine, benzylamine and phenethylamine. Examples of suitable secondary aliphatic amines include dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, and N,N-dimethyltetraethylenepentamine. Examples of suitable tertiary aliphatic amines include trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, and N,N,N',N'-tetramethyltetraethylenepentamine.

Also included in the aliphatic amines are mixed amines such as dimethylethylamine, methylethylpropylamine, and benzyldimethylamine.

Examples of suitable aromatic and heterocyclic amines include aniline derivatives (e.g., aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, and N,N-dimethyltoluidine), diphenyl(p-tolyl)amine, methyldiphenylamine, triphenylamine, phenylenediamine, naphthylamine, diaminonaphthalene, pyrrole derivatives (e.g., pyrrole, 2H-pyrrole, 1-methylpyrrole, 2,4-dimethylpyrrole, 2,5-dimethylpyrrole, and N-methylpyrrole), oxazole derivatives (e.g., oxazole and isooxazole), thiazole derivatives (e.g., thiazole and isothiazole), imidazole derivatives (e.g., imidazole, 4-methylimidazole, and 4-methyl-2-phenylimidazole), pyrazole derivatives, furazan derivatives, pyrroline derivatives (e.g., pyrroline and 2-methyl-1-pyrroline), pyrrolidine derivatives (e.g., pyrrolidine, N-methylpyrrolidine, pyrrolidinone, and N-methylpyrrolidone), imidazoline derivatives, imidazolidine derivatives, pyridine derivatives (e.g., pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridine, 4-pyrrolidinopyridine, 1-methyl-4-phenylpyridine, 2-(1-ethylpropyl)pyridine, aminopyridine, and dimethylaminopyridine), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (e.g., quinoline and 3-quinolinecarbonitrile), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, and uridine derivatives.

Examples of suitable nitrogen-containing compounds with carboxyl group include aminobenzoic acid, indolecarboxylic acid, and amino acid derivatives (e.g. nicotinic acid, alanine, alginine, aspartic acid, glutamic acid, glycine, histidine, isoleucine, glycylleucine, leucine, methionine, phenylalanine, threonine, lysine, 3-aminopyrazine-2-carboxylic acid, and methoxyalanine). Examples of suitable nitrogen-containing compounds with sulfonyl group include 3-pyridinesulfonic acid and pyridinium p-toluenesulfonate. Examples of suitable nitrogen-containing compounds with hydroxyl group, nitrogen-containing compounds with hydroxyphenyl group, and alcoholic nitrogen-containing compounds include 2-hydroxypyridine, aminocresol, 2,4-quinolinediol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl)piperazine, 1-[2-(2-hydroxyethoxy)ethyl]piperazine, piperidine ethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyjulolidine, 3-quinuclidinol, 3-tropanol, 1-methyl-2-pyrrolidine ethanol, 1-aziridine ethanol, N-(2-hydroxyethyl)phthalimide, and N-(2-hydroxyethyl)isonicotinamide.

Examples of suitable amide derivatives include formamide, N-methylformamide, N,N-dimethylformamide, acetamide, N-methylacetamide, N,N-dimethylacetamide, propionamide, and benzamide. Suitable imide derivatives include phthalimide, succinimide, and maleimide.

In addition, one or more of basic compounds of the following general formula (B)-1 may also be included.

N(Z)ₙ(Y)₃₋ₙ (B)-1

In the formula, n is equal to 1, 2 or 3; Y is independently hydrogen or a straight, branched or cyclic alkyl group of 1 to 20 carbon atoms which may contain a hydroxyl group or ether group; and Z is independently selected from groups of the following general formulas (Z)-1 to (Z)-3, and two or three Z may bond together to form a ring.

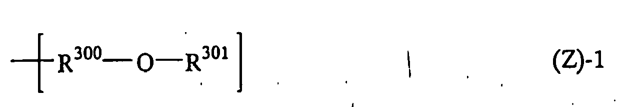

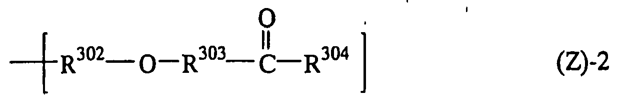

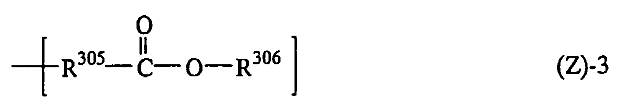

In the formulas, R³⁰⁰, R³⁰² and R³⁰⁵ are independently straight or branched alkylene groups of 1 to 4 carbon atoms; R³⁰¹ and R³⁰⁴ are independently hydrogen or straight, branched or cyclic alkyl groups of 1 to 20 carbon atoms, which may contain at least one hydroxyl group, ether group, ester group or lactone ring; R³⁰³ is a single bond or a straight or branched alkylene group of 1 to 4 carbon atoms; and R³⁰⁶ is a straight, branched or cyclic alkyl group of 1 to 20 carbon atoms, which may contain at least one hydroxyl group, ether group, ester group or lactone ring.

Illustrative examples of the basic compounds of formula (B)-1 include, but are not limited to, tris[(2-methoxymethoxy)ethyl]amine, tris[2-(2-methoxyethoxy)ethyl]amine, tris[2-(2-methoxyethoxymethoxy)ethyl]amine, tris[2-(1-methoxyethoxy)ethyl]amine, tris[2-(1-ethoxyethoxy)ethyl]amine, tris[2-(1-ethoxypropoxy)ethyl]amine, tris[2-{2-(2-hydroxyethoxy)ethoxy}ethyl]amine, 4,7,13,16,21,24-hexaoxa-1,10-diazabicyclo[8.8.8]hexacosane, 4,7,13,18-tetraoxa-1,10-diazabicyclo[8.5.5]eicosane, 1,4,10,13-tetraoxa-7,16-diazabicyclooctadecane, 1-aza-12-crown-4, 1-aza-15-crown-5, 1-aza-18-crown-6, tris(2-formyloxyethyl)amine, tris(2-acetoxyethyl)amine, tris(2-propionyloxyethyl)amine, tris(2-butyryloxyethyl)amine, tris(2-isobutyryloxyethyl)amine, tris(2-valeryloxyethyl)amine, tris(2-pivaloyloxyethyl)amine, N,N-bis(2-acetoxyethyl)-2-(acetoxyacetoxy)ethylamine, tris(2-methoxycarbonyloxyethyl)amine, tris(2-tert-butoxycarbonyloxyethyl)amine, tris[2-(2-oxopropoxy)ethyl]amine, tris[2-(methoxycarbonylmethyl)oxyethyl]amine, tris[2-(tert-butoxycarbonylmethyloxy)ethyl]amine, tris[2-(cyclohexyloxycarbonylmethyloxy)ethyl]amine, tris(2-methoxycarbonylethyl)amine, tris(2-ethoxycarbonylethyl)amine, N,N-bis(2-hydroxyethyl)-2-(methoxycarbonyl)ethylamine, N,N-bis(2-acetoxyethyl)-2-(methoxycarbonyl)ethylamine, N,N-bis(2-hydroxyethyl)-2-(ethoxycarbonyl)ethylamine, N,N-bis(2-acetoxyethyl)-2-(ethoxycarbonyl)ethylamine, N,N-bis(2-hydroxyethyl)-2-(2-methoxyethoxycarbonyl)ethylamine, N,N-bis(2-acetoxyethyl)-2-(2-methoxyethoxycarbonyl)ethylamine, N,N-bis(2-hydroxyethyl)-2-(2-hydroxyethoxycarbonyl)ethylamine, N,N-bis(2-acetoxyethyl)-2-(2-acetoxyethoxycarbonyl)ethylamine, N,N-bis(2-hydroxyethyl)-2-[(methoxycarbonyl)methoxycarbonyl]-ethylamine, N,N-bis(2-acetoxyethyl)-2-[(methoxycarbonyl)methoxycarbonyl]-ethylamine, N,N-bis(2-hydroxyethyl)-2-(2-oxopropoxycarbonyl)ethylamine, N,N-bis(2-acetoxyethyl)-2-(2-oxopropoxycarbonyl)ethylamine, N,N-bis(2-hydroxyethyl)-2-(tetrahydrofurfuryloxycarbonyl)-ethylamine, N,N-bis(2-acetoxyethyl)-2-(tetrahydrofurfuryloxycarbonyl)-ethylamine, N,N-bis(2-hydroxyethyl)-2-[(2-oxotetrahydrofuran-3-yl)oxycarbonyl]ethylamine, N,N-bis(2-acetoxyethyl)-2-[(2-oxotetrahydrofuran-3-yl)oxycarbonyl]ethylamine, N,N-bis(2-hydroxyethyl)-2-(4-hydroxybutoxycarbonyl)ethylamine, N,N-bis(2-formyloxyethyl)-2-(4-formyloxybutoxycarbonyl)-ethylamine, N,N-bis(2-formyloxyethyl)-2-(2-formyloxyethoxycarbonyl)-ethylamine, N,N-bis(2-methoxyethyl)-2-(methoxycarbonyl)ethylamine, N-(2-hydroxyethyl)-bis[2-(methoxycarbonyl)ethyl]amine, N-(2-acetoxyethyl)-bis[2-(methoxycarbonyl)ethyl]amine, N-(2-hydroxyethyl)-bis[2-(ethoxycarbonyl)ethyl]amine, N-(2-acetoxyethyl)-bis[2-(ethoxycarbonyl)ethyl]amine, N-(3-hydroxy-1-propyl)-bis[2-(methoxycarbonyl)ethyl]amine, N-(3-acetoxy-1-propyl)-bis[2-(methoxycarbonyl)ethyl]amine, N-(2-methoxyethyl)-bis[2-(methoxycarbonyl)ethyl]amine, N-butyl-bis[2-(methoxycarbonyl)ethyl]amine, N-butyl-bis[2-(2-methoxyethoxycarbonyl)ethyl]amine, N-methyl-bis(2-acetoxyethyl)amine, N-ethyl-bis(2-acetoxyethyl)amine, N-methyl-bis(2-pivaloyloxyethyl)amine, N-ethyl-bis[2-(methoxycarbonyloxy)ethyl]amine, N-ethyl-bis[2-(tert-butoxycarbonyloxy)ethyl]amine, tris(methoxycarbonylmethyl)amine, tris(ethoxycarbonylmethyl)amine, N-butyl-bis(methoxycarbonylmethyl)amine, N-hexyl-bis(methoxycarbonylmethyl)amine, and β-(diethylamino)-δ-valerolactone.

The basic compounds may be used alone or in admixture of two or more. The basic compound is preferably formulated in an amount of 0 to 2 parts, and especially 0.01 to 1 part by weight, per 100 parts by weight of the polymer or base resin in the resist composition. The use of more than 2 parts of the basis compound may result in too low a sensitivity.

### Surfactant

In the chemically amplified negative resist composition, a surfactant may be added for improving coating characteristics.

Illustrative, non-limiting, examples of the surfactant include nonionic surfactants, for example, polyoxyethylene alkyl ethers such as polyoxyethylene lauryl ether, polyoxyethylene stearyl ether, polyoxyethylene cetyl ether, and polyoxyethylene oleyl ether, polyoxyethylene alkylaryl ethers such as polyoxyethylene octylphenol ether and polyoxyethylene nonylphenol ether, polyoxyethylene polyoxypropylene block copolymers, sorbitan fatty acid esters such as sorbitan monolaurate, sorbitan monopalmitate, and sorbitan monostearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorochemical surfactants such as EFTOP EF301, EF303 and EF352 (Tohkem Products Co., Ltd.), Megaface F171, F172 and F173 (Dainippon Ink & Chemicals, Inc.), Fluorad FC430 and FC431 (Sumitomo 3M Co., Ltd.), Aashiguard AG710, Surflon S-381, S-382, SC101, SC102, SC103, SC104, SC105, SC106, Surfynol E1004, KH-10, KH-20, KH-30 and KH-40 (Asahi Glass Co., Ltd.); organosiloxane polymers KP341, X-70-092 and X-70-093 (Shin-Etsu Chemical Co., Ltd.), acrylic acid or methacrylic acid Polyflow No. 75 and No. 95 (Kyoeisha Ushi Kagaku Kogyo K.K.). Inter alia, Fluorad FC430, Surflon S-381, Surfynol E1004, KH-20 and KH-30 are preferred. These surfactants may be used alone or in admixture.

In the chemically amplified negative resist composition, the surfactant is preferably formulated in an amount of up to 2 parts, and especially up to 1 part by weight, per 100 parts by weight of the polymer or base resin.

### Organic solvent

In the negative resist composition, an organic solvent may be added. Illustrative, non-limiting, examples include butyl acetate, amyl acetate, cyclohexyl acetate, 3-methoxybutyl acetate, methyl ethyl ketone, methyl amyl ketone, cyclohexanone, cyclopentanone, 3-ethoxyethyl propionate, 3-ethoxymethyl propionate, 3-methoxymethyl propionate, methyl acetoacetate, ethyl acetoacetate, diacetone alcohol, methyl pyruvate, ethyl pyruvate, propylene glycol monomethyl ether, propylene glycol monoethyl ether, propylene glycol monomethyl ether propionate, propylene glycol monoethyl ether propionate, ethylene glycol monomethyl ether, ethylene glycol monoethyl ether, diethylene glycol monomethyl ether, diethylene glycol monoethyl ether, 3-methyl-3-methoxybutanol, N-methylpyrrolidone, dimethyl sulfoxide, γ-butyrolactone, propylene glycol alkyl ether acetates such as propylene glycol methyl ether acetate, propylene glycol ethyl ether acetate, and propylene glycol propyl ether acetate, alkyl lactates such as methyl lactate, ethyl lactate, and propyl lactate, and tetramethylene sulfone.

Of these, the propylene glycol alkyl ether acetates and alkyl lactates are especially preferred. The solvents may be used alone or in admixture of two or more. An exemplary useful solvent mixture is a mixture of propylene glycol alkyl ether acetates and/or alkyl lactates. It is noted that the alkyl groups of the propylene glycol alkyl ether acetates are preferably those of 1 to 4 carbon atoms, for example, methyl, ethyl and propyl, with methyl and ethyl being especially preferred. Since the propylene glycol alkyl ether acetates include 1,2- and 1,3-substituted ones, each includes three isomers depending on the combination of substituted positions, which may be used alone or in admixture. It is also noted that the alkyl groups of the alkyl lactates are preferably those of 1 to 4 carbon atoms, for example, methyl, ethyl and propyl, with methyl and ethyl being especially preferred.

When the propylene glycol alkyl ether acetate is used as the solvent, it preferably accounts for at least 50% by weight of the entire solvent. Also when the alkyl lactate is used as the solvent, it preferably accounts for at least 50% by weight of the entire solvent. When a mixture of propylene glycol alkyl ether acetate and alkyl lactate is used as the solvent, that mixture preferably accounts for at least 50% by weight of the entire solvent. In this solvent mixture, it is further preferred that the propylene glycol alkyl ether acetate is 5 to 40% by weight and the alkyl lactate is 60 to 95% by weight. A lower proportion of the propylene glycol alkyl ether acetate would invite a problem of inefficient coating whereas a higher proportion thereof would provide insufficient dissolution and allow for particle and foreign matter formation. A lower proportion of the alkyl lactate would provide insufficient dissolution and cause the problem of many particles and foreign matter whereas a higher proportion thereof would lead to a composition which has a too high viscosity to apply and loses storage stability.

In the negative resist composition, the solvent is preferably used in an amount of 300 to 2,000 parts by weight, especially 400 to 1,000 parts by weight per 100 parts by weight of the polymer or base resin. The concentration of the resulting composition is not limited thereto as long as a film can be formed by existing methods.

While the negative resist composition comprising the polymer of formula (1), photoacid generator, crosslinker and optionally basic compound, surfactant, organic solvent and the like is typically used in the microfabrication of many integrated circuits, any well-known lithography may be used to form a resist pattern from the resist composition. Since the negative resist composition is found generally to be highly reactive and sensitive to electron beam and remains stable in vacuum with time, the composition is particularly useful in the EB lithography.

In a typical process of forming a resist pattern from the negative resist composition, the composition is first applied onto a substrate by a coating technique. Suitable substrates includechromium or chromium compound films on photomask-forming blanks, or films of chromium compounds like oxides, nitrides, oxynitrides, oxycarbides, nitride carbides, and oxide nitride carbides, deposited on substrates by sputtering. Suitable coating techniques include spin coating, roll coating, flow coating, dip coating, spray coating or doctor coating. The coating is then prebaked on a hot plate at a temperature of 60 to 150°C for about 1 to 20 minutes, preferably 80 to 120°C for about 1 to 10 minutes. The resulting resist film is generally 0.1 to 2.0 µm thick.

The resist film is then exposed to high-energy radiation from a light source selected from UV, deep-UV, x-ray, excimer laser light, γ-ray and synchrotron radiation sources, preferably radiation having an exposure wavelength of up to 300 nm or electron beam, directly or through a mask having a desired pattern. An appropriate exposure dose is about 1 to 200 mJ/cm², preferably about 10 to 100 mJ/cm² in the case of radiation exposure, and about 0.1 to 20 µC/cm², preferably about 3 to 10 µC/cm² in the case of EB exposure. Subsequently, the film is preferably baked on a hot plate at 60 to 150°C for about 1 to 20 minutes, more preferably 80 to 120°C for about 1 to 10 minutes (post-exposure baking = PEB).

Thereafter the resist film is developed with a developer in the form of an aqueous base solution, for example, an aqueous solution of 0.1-5 wt%, preferably 2-3 wt% tetramethylammonium hydroxide (TMAH) for 0.1 to 3 minutes, preferably 0.5 to 2 minutes by a conventional technique such as dip, puddle or spray technique. The exposed regions of the resist film where the base resin has been crosslinked are not dissolved in the developer substantially whereas the unexposed regions of the resist film are dissolved in the developer. In this way, a desired resist pattern is formed on the substrate.

It is appreciated that the invention is suited for micropatterning using such high-energy radiation as deep UV with a wavelength of 254 to 193 nm, vacuum UV with a wavelength of 157 nm, electron beam, x-rays, soft x-rays, excimer laser light, γ-rays and synchrotron radiation, and best suited for micropatterning with electron beam.

### EXAMPLE

Synthesis Examples, Comparative Synthesis Examples, Examples, and Comparative Examples are given below by way of illustration and not by way of limitation. The average molecular weights including weight average molecular weight (Mw) and number average molecular weight (Mn) are determined by gel permeation chromatography (GPC) versus polystyrene standards.

### General synthesis of base polymer

A flask was charged with acetoxystyrene and indene and toluene as a solvent. Once the reactor was cooled to -70°C in a nitrogen blanket, vacuum evacuation and nitrogen flow were repeated three times. The reactor was warmed to room temperature, fed with a polymerization initiator, and heated at 55°C whereupon reaction took place for 40 hours. The reaction solution was concentrated to a half volume and added dropwise to methanol for precipitation. The resulting white solids were collected by filtration and dried in vacuo at 40°C, leaving a white polymer. The polymer was dissolved again in an approximately 6 V/W amount of 1/1 methanol/tetrahydrofuran, whereupon a 0.7 V/W amount of triethylamine and a 0.15 V/W amount of water were added to the polymer solution (V/W designating the volume of fluid divided by the weight of polymer). Deblocking reaction occurred, after which acetic acid was added for neutralization. The reaction solution was then concentrated and dissolved in acetone. This was followed by precipitation, filtration and drying as above, yielding a white polymer.

The polymer was analyzed by ¹³C-NMR, ¹H-NMR and GPC, from which the composition and molecular weight were determined.

### General acylation (acid halide)

A flask was charged with the base polymer and tetrahydrofuran (THF) as a solvent. The reactor was cooled to 10°C in a nitrogen atmosphere whereupon an excess amount of triethylamine was added and an appropriate amount of acid chloride was added dropwise. The reactor was warmed to room temperature, at which reaction took place for 3 hours. The reaction solution was concentrated to a half volume, and poured into a solution of acetic acid (in an amount to neutralize the triethylamine) in water for precipitation. The resulting white solids were dissolved in acetone, added dropwise to water for precipitation, filtered, and dried in vacuo at 40°C, leaving a white polymer. The polymer was analyzed by ¹³C-NMR and ¹H-NMR, from which the composition was identified.

### General butoxycarbonylation (di-tert-butyl dicarbonate)

A flask was charged with the base polymer and THF as a solvent. The reactor was cooled to 10°C in a nitrogen atmosphere whereupon an excess amount of triethylamine was added and an appropriate amount of di-tert-butyl dicarbonate was added dropwise. The reactor was heated to 50°C, at which reaction took place for 3 hours. The reaction solution was concentrated to a half volume, and poured into a solution of acetic acid (in an amount to neutralize the triethylamine) in water for precipitation. The resulting white solids were dissolved in acetone, added dropwise to water for precipitation, filtered, and dried in vacuo at 40°C, leaving a white polymer. The polymer was analyzed by ¹³C-NMR and ¹H-NMR, from which the composition was identified.

### Synthesis Example 1

Reaction was carried out in accordance with the aforementioned synthesis procedure using 964 g of acetoxystyrene, 960 g of indene, 200 g of toluene and 98 g of azobisisobutyronitrile (AIBN) as a reaction initiator. There was obtained 780 g of a polymer, designated Poly-A.
Copolymer compositional ratio (molar ratio)
hydroxystyrene : indene = 82.2:17.8
Mw = 3,700
Dispersity Mw/Mn = 1.95

### Synthesis Example 2

Reaction was carried out in accordance with the aforementioned synthesis procedure using 964 g of acetoxystyrene, 960 g of indene, 150 g of toluene and 98 g of AIBN reaction initiator. There was obtained 790 g of a polymer, designated Poly-B.
Copolymer compositional ratio (molar ratio)
hydroxystyrene : indene = 82.5:17.5
Mw = 4,500
Dispersity Mw/Mn = 1.98

### Synthesis Example 3

Reaction was carried out in accordance with the aforementioned synthesis procedure using 852 g of acetoxystyrene, 1044 g of indene, 300 g of toluene and 98 g of AIBN reaction initiator. There was obtained 660 g of a polymer, designated Poly-C.
Copolymer compositional ratio (molar ratio)
hydroxystyrene : indene = 81.9:18.1
Mw = 2,600
Dispersity Mw/Mn = 1.52

### Synthesis Example 4

Reaction was carried out in accordance with the aforementioned synthesis procedure using 964 g of acetoxystyrene, 960 g of indene, 150 g of toluene and 295 g of 2,2'-azobis(2,4-dimethylvaleronitrile) as a reaction initiator. There was obtained 620 g of a polymer, designated Poly-D.
Copolymer compositional ratio (molar ratio)
hydroxystyrene : indene = 74.3:25.7
Mw = 2,500
Dispersity Mw/Mn = 1.50

Synthesis Examples 5 to 14 are described below. The polymers obtained therein have a Mw and a dispersity Mw/Mn which are substantially equivalent to those of Poly-A to D from which they are derived.

### Synthesis Examples 5 to 7

Acetylation was carried out in accordance with the aforementioned synthesis procedure using 30 g of Poly-A, 270 g of THF, 12 g of triethylamine and 2.2 g of acetic acid chloride. After the reaction, the reaction solution was concentrated and poured into a solution of 30 g acetic acid in 5 L water for precipitation. The resulting white solids were dissolved in 150 g of acetone again, and precipitated in 5 L of water, followed by filtration and drying. There was obtained 28 g of a white polymer, designated Poly-1. Copolymer compositional ratio (molar ratio)
hydroxystyrene : 4-acetoxystyrene : indene =
74.9:7.5:17.6

In accordance with a similar formulation, Poly-2 and Poly-3 were obtained from Poly-B and Poly-C, respectively. Copolymer compositional ratio (molar ratio)
Poly-2
hydroxystyrene : 4-acetoxystyrene : indene = 74.5:8.0:17.5
Poly-3
hydroxystyrene : 4-acetoxystyrene : indene = 74.2:7.7:18.1

### Synthesis Examples 8 to 11

White polymers were obtained from 30 g of Poly-A in accordance with the formulation of Synthesis Example 5 aside from using n-propionic acid chloride, n-butanoic acid chloride, n-pentanoic acid chloride, and pivaloyl chloride, each 2.2 g, as the acid chloride or polymer modifying reagent.

### Copolymer compositional ratio (molar ratio)

Poly-4
hydroxystyrene : 4-n-propionyloxystyrene : indene = 75.8:6.4:17.8
Poly-5
hydroxystyrene : 4-n-butanoyloxystyrene : indene = 76.7:5.5:17.8
Poly-6
hydroxystyrene : 4-n-pentanoyloxystyrene : indene = 77.2:4.9:17.9
Poly-7
hydroxystyrene : pivaloyloxystyrene : indene = 77.6:4.7:17.7

### Synthesis Examples 12 to 14

Butoxycarbonylation was carried out in accordance with the aforementioned butoxycarbonylation procedure using 30 g of Poly-A, 270 g of THF, 12 g of triethylamine and 1.9 g of di-tert-butyl dicarbonate. After the reaction, the reaction solution was concentrated and poured into a solution of 30 g acetic acid in 5 L water for precipitation. The resulting white solids were dissolved in 150 g of acetone again, and precipitated in 5 L of water, followed by filtration and drying. There was obtained 26 g of a white polymer, designated Poly-8.
Copolymer compositional ratio (molar ratio)
Poly-8
hydroxystyrene : 4-tert-butoxycarbonyloxystyrene : indene = 77.7:4.7:17.6

In accordance with a similar formulation, Poly-9 and Poly-10 were obtained from Poly-B and Poly-C, respectively. Copolymer compositional ratio (molar ratio)
Poly-9
hydroxystyrene : 4-tert-butoxycarbonyloxystyrene : indene = 77.6:4.9:17.5
Poly-10
hydroxystyrene : 4-tert-butoxycarbonyloxystyrene : indene = 76.9:5.0:18.1

### Examples 1 to 26 and Comparative Examples 1 to 3

Resist compositions were prepared in accordance with the formulation shown in Tables 1 to 3. Each of the resist compositions was filtered through a 0.2-µm fluoropolymer filter and then spin-coated onto a silicon wafer (reference) or onto a chromium film on silicon wafer, so as to give a dry thickness of 0.3 µm.

The coated wafer was then baked on a hot plate at 110°C for 4 minutes. The resist films were exposed to electron beam using an EB exposure system HL-800D (Hitachi High-Technologies Corp., accelerating voltage 50 keV), then baked (PEB) at 120°C for 4 minutes, and developed with a solution of 2.38% tetramethylammonium hydroxide in water, thereby giving a negative pattern.

The resulting resist patterns were evaluated as described below.

The optimum exposure dose (sensitivity Eop) was the exposure dose which provided a 1:1 resolution at the top and bottom of a 0.20-µm line-and-space pattern. The minimum line width (µm) of a line-and-space pattern which was ascertained separate at this dose was the resolution of a test resist. The shape in cross section of the resolved resist pattern was examined under a scanning electron microscope.

The evaluated results of sensitivity, limit resolution, pattern profile on silicon wafer (pattern profile on Si), and pattern profile on chromium film on silicon wafer (pattern profile on Cr) are shown in Table 4.

The components used in the resist compositions and shown in Tables 1 to 3 are identified below.
Crosslinker 1: hexamethoxymethylmelamine
Crosslinker 2: triallyl cyanurate
Crosslinker 3: 2,4,6-tris(2,3-epoxypropoxy)-1,3,5-triazine
Crosslinker 4: tetramethoxymethylglycoluril
Photoacid generator 1: triphenylsulfonium toluenesulfonate
Photoacid generator 2: triphenylsulfonium camphorsulfonate
Base 1: tri-n-butylamine
Base 2: tris[2-(methoxymethoxy)ethyl]amine
Surfactant 1: Fluorad FC-430 (Sumitomo 3M Co., Ltd.)
Solvent 1: ethyl lactate

**Table 1**

| Component (pbw) | Example | | | | | | | | | |
|---|---|---|---|---|---|---|---|---|---|---|
| | 1 | 2 | 3 | 4 | 5 | 6 | 7 | 8 | 9 | 10 |
| Poly-1 | 80 | | | | | | | | | |
| Poly-2 | | 80 | | | | | | | | |
| Poly-3 | | | 80 | | | | | | | |
| Poly-4 | | | | 80 | | | | | | |
| Poly-5 | | | | | 80 | | | | | |
| Poly-6 | | | | | | 80 | | | | |
| Poly-7 | | | | | | | 80 | | | |
| Poly-8 | | | | | | | | 80 | | |
| Poly-9 | | | | | | | | | 80 | |
| Poly-10 | | | | | | | | | | 80 |
| Crosslinker 1 | 10 | 10 | 10 | 10 | 10 | 10 | 10 | 10 | 10 | 10 |
| Photoacid generator 1 | 10 | 10 | 10 | 10 | 10 | 10 | 10 | 10 | 10 | 10 |
| Base 1 | 0.5 | 0.5 | 0.5 | 0.5 | 0.5 | 0.5 | 0.5 | 0.5 | 0.5 | 0.5 |
| Surfactant 2 | 0.2 | 0.2 | 0.2 | 0.2 | 0.2 | 0.2 | 0.2 | 0.2 | 0.2 | 0.2 |
| Solvent 1 | 1,300 | 1,300 | 1,300 | 1,300 | 1,300 | 1,300 | 1,300 | 1,300 | 1,300 | 1,300 |

**Table 2**

| Component (pbw) | Example | | | | | | | | | |
|---|---|---|---|---|---|---|---|---|---|---|
| | 11 | 12 | 13 | 14 | 15 | 16 | 17 | 18 | 19 | 20 |
| Poly-1 | 40 | | 40 | 20 | | | | | | |
| Poly-2 | 40 | 40 | | 40 | | | | 40 | 60 | 60 |
| Poly-3 | | 40 | 40 | 20 | | | | | | |
| Poly-4 | | | | | | | | | | |
| Poly-5 | | | | | | | | | | |
| Poly-6 | | | | | | | | | | |
| Poly-7 | | | | | | | | | | |
| Poly-8 | | | | | 40 | | 40 | 40 | | |
| Poly-9 | | | | | 40 | 40 | | | | |
| Poly-10 | | | | | | 40 | 40 | | | |
| Poly-A | | | | | | | | | 20 | |
| Poly-D | | | | | | | | | | 20 |
| Crosslinker 1 | 10 | 10 | 10 | 10 | 10 | 10 | 10 | 10 | 10 | 10 |
| Photoacid generator 1 | 10 | 10 | 10 | 10 | 10 | 10 | 10 | 10 | 10 | 10 |
| Base 1 | 0.5 | 0.5 | 0.5 | 0.5 | 0.5 | 0.5 | 0.5 | 0.5 | 0.5 | 0.5 |
| Surfactant 1 | 0.2 | 0.2 | 0.2 | 0.2 | 0.2 | 0.2 | 0.2 | 0.2 | 0.2 | 0.2 |
| Solvent 1 | 1,300 | 1,300 | 1,300 | 1,300 | 1,300 | 1,300 | 1,300 | 1,300 | 1,300 | 1,300 |

**Table 3**

| Component (pbw) | Example | | | | | | Comparative Example | | |
|---|---|---|---|---|---|---|---|---|---|
| | 21 | 22 | 23 | 24 | 25 | 26 | 1 | 2 | 3 |
| Poly-1 | 80 | 80 | 80 | 80 | 80 | 80 | | | |
| Poly-2 | | | | | | | | | |
| Poly-3 | | | | | | | | | |
| Poly-4 | | | | | | | | | |
| Poly-5 | | | | | | | | | |
| Poly-6 | | | | | | | | | |
| Poly-7 | | | | | | | | | |
| Poly-8 | | | | | | | | | |
| Poly-9 | | | | | | | | | |
| Poly-10 | | | | | | | | | |
| Poly-A | | | | | | | 80 | | |
| Poly-B | | | | | | | | 80 | |
| Poly-D | | | | | | | | | 80 |
| Crosslinker 1 | 5 | 5 | 5 | | 10 | | 10 | 10 | 10 |
| Crosslinker 2 | 5 | | | 10 | | 10 | | | |
| Crosslinker 3 | | 5 | | | | | | | |
| Crosslinker 4 | | | 5 | | | | | | |
| Photoacid generator 1 | 10 | 10 | 10 | 10 | | 10 | 10 | 10 | 10 |
| Base 1 | 0.5 | 0.5 | 0.5 | 0.5 | | | 0.5 | 0.5 | 0.5 |
| Base 2 | | | | | 0.5 | 0.5 | | | |
| Surfactant 1 | 0.2 | 0.2 | 0.2 | 0.2 | 0.2 | 0.2 | 0.2 | 0.2 | 0.2 |
| Solvent 1 | 1,300 | 1,300 | 1,300 | 1,300 | 1,300 | 1,300 | 1,300 | 1,300 | 1,300 |

**Table 4**

| | Eop (µC/cm²) | Resolution limit (nm) | Pattern profile on Si [reference] | Pattern profile on Cr |
|---|---|---|---|---|
| Example 1 | 9.8 | 80 | rectangular | rectangular |
| Example 2 | 7.9 | 75 | rectangular | slightly undercut |
| Example 3 | 12.2 | 90 | rectangular | rectangular |
| Example 4 | 9.7 | 100 | slightly tapered | slightly tapered |
| Example 5 | 9.6 | 100 | rectangular | rectangular |
| Example 6 | 9.5 | 100 | rectangular | rectangular |
| Example 7 | 9.2 | 90 | some footing | some footing |
| Example 8 | 9.5 | 80 | rectangular | rectangular |
| Example 9 | 7.2 | 80 | rectangular | slightly undercut |
| Example 10 | 11.3 | 90 | rectangular | rectangular |
| Example 11 | 9.0 | 75 | rectangular | rectangular |
| Example 12 | 9.6 | 85 | rectangular | rectangular |
| Example 13 | 11.0 | 80 | rectangular | rectangular |
| Example 14 | 9.3 | 85 | rectangular | rectangular |
| Example 15 | 8.7 | 80 | rectangular | rectangular |
| Example 16 | 9.2 | 85 | rectangular | rectangular |
| Example 17 | 10.5 | 90 | rectangular | rectangular |
| Example 18 | 8.7 | 90 | rectangular | rectangular |
| Example 19 | 8.0 | 95 | rectangular | slightly undercut |
| Example 20 | 8.1 | 95 | slightly tapered, some footing | slightly tapered, undercut |
| Example 21 | 12.4 | 80 | rectangular | rectangular |
| Example 22 | 13.0 | 100 | rectangular | rectangular |
| Example 23 | 10.2 | 105 | rectangular | rectangular |
| Example 24 | 10.0 | 75 | rectangular | rectangular |
| Example 25 | 11.5 | 85 | rectangular | rectangular |
| Example 26 | 11.7 | 85 | rectangular | rectangular |
| Comparative Example 1 | 10.1 | 100 | rectangular | undercut |
| Comparative Example 2 | 9.5 | 105 | rectangular | undercut |
| Comparative Example 3 | 13.1 | 110 | tapered, footing | tapered, undercut |

From the test results, the following is ascertained. A comparison of Examples 1 and 4-8 with Comparative Example 1 reveals that when some of hydrogen atoms of phenolic hydroxyl groups on hydroxystyrene-indene copolymers are replaced by alkylcarbonyl or alkoxycarbonyl groups having a side chain of 1 to 4 carbon atoms, patterns which are satisfactory due to minimized undercut in proximity to the substrate are obtained and that alkyl or alkoxy groups of branched structure are advantageous among the groups of at least 3 carbon atoms. Now that Examples 3 and 10 use Poly-3 and Poly-10 in which some of hydroxystyrene units imparting alkali solubility to Poly-C are substituted with acyl groups, and Comparative Example 3 uses Poly-D which is regarded as a polymer having some of hydroxystyrene units of Poly-C replaced by indene units that have no alkali solubility, a comparison of Examples 3 and 10 with Comparative Example 3 reveals that Examples 3 and 10 form better patterns substantially free of undercut.

A comparison of Examples 11-14 with Example 1 and a comparison of Examples 15-17 with Example 8 reveal that a mixture of polymers having different molecular weights forms a pattern of better profile with minimal line edge roughness (or minimal profile roughening at the pattern edge). With respect to line edge roughness, better results are obtained when a polymer with a molecular weight of less than 4,000 and a polymer with a molecular weight of at least 4,000 are mixed.

## Claims

1. A process for forming a resist pattern, comprising the steps of:
applying a negative resist composition onto a chromium or chromium compound film deposited on a substrate by sputtering, to form a coating,
heat treating the coating and exposing the coating to high-energy radiation,
optionally heat treating the exposed coating, and developing the coating with a developer,
said negative resist composition comprising
a polymer comprising recurring units having the general formula (1): 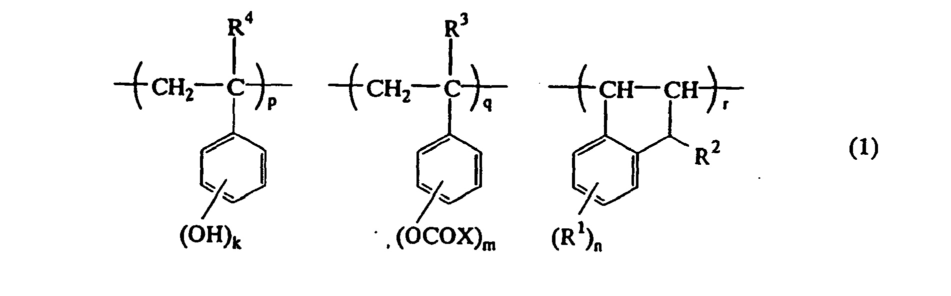 wherein X is a straight or branched alkyl group of 1 to 4 carbon atoms or a straight or branched alkoxy group of 1 to 4 carbon atoms, R¹ and R² are each independently a hydrogen atom, hydroxy group, straight or branched alkyl group, alkoxy group which may be substituted, or halogen atom, R³ and R⁴ are hydrogen or methyl, n is a positive integer of 1 to 4, m and k each are a positive integer of 1 to 5, p, q, r are positive numbers, the polymer having a weight average molecular weight of 1,000 to 500,000,
a photoacid generator capable of generating acid upon exposure to high-energy radiation, and
a crosslinker capable of inducing crosslinkage to the polymer with the aid of the acid generated by the photoacid generator.

2. A process according to claim 1, wherein said substrate is a photomask-forming blank.

3. A process according to claim 1 or 2, wherein the high-energy radiation comprises electron beam.

4. A process according to any one of claims 1 to 3, wherein the negative resist composition is formulated as a chemically amplified negative resist composition further comprising (A) a basic compound, (B) a surfactant, and (C) an organic solvent.

5. A process according to any one of claims 1-4, wherein X is a group selected from methyl, tert-butyl, methoxy, and tert-butoxy.

6. A process according to any one of claims 1-5, wherein the following inequalities are satisfied:
0<r/(p+q+r)≤0.3
0<q/(p+q+r)≤0.15

7. A process according to any one of claims 1-6, wherein R¹ and R² is each independently: an alkyl group selected from methyl, ethyl, propyl, isopropyl, n-butyl, isobutyl, and tert-butyl; or an alkoxy group selected from methoxy ethoxy, propoxy, n-butoxy, isobutoxy, and tert-butoxy which is optionally substituted with a group selected from: an epoxy group; a hydroxy group; or a halogen atom.

## Patentansprüche

1. Verfahren zur Herstellung einer Resiststruktur, das die folgenden Schritte umfasst:
Auftragen einer Negativresistzusammensetzung auf einen durch Sputtern auf ein Substrat aufgebrachten Chrom- oder Chromverbindungsfilm, um eine Beschichtung zu bilden,
Wärmebehandeln der Beschichtung und Aussetzen der Beschichtung gegenüber Hochenergiestrahlung,
gegebenenfalls Wärmebehandeln der bestrahlten Beschichtung und Entwickeln der Beschichtung mit einem Entwickler,
wobei die Negativresistzusammensetzung Folgendes umfasst:
ein Polymer, das Grundeinheiten der allgemeinen Formel (1) umfasst: 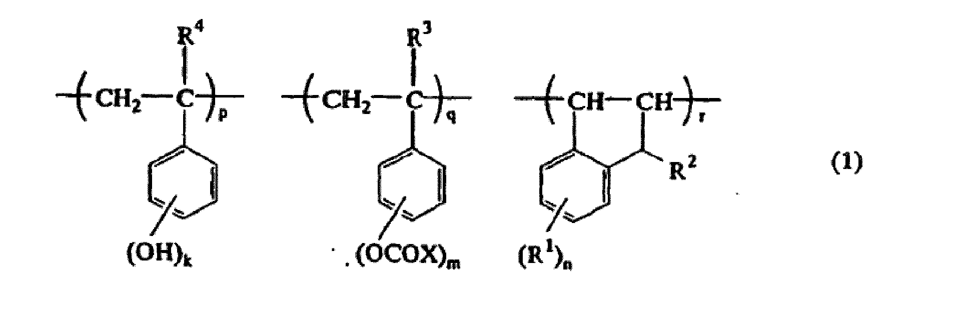 worin X eine unverzweigte oder verzweigte Alkylgruppe mit 1 bis 4 Kohlenstoffatomen oder eine unverzweigte oder verzweigte Alkoxygruppe mit 1 bis 4 Kohlenstoffatomen ist, R¹ und R² jeweils unabhängig voneinander ein Wasserstoffatom, eine Hydroxygruppe, eine unverzweigte oder verzweigte Alkylgruppe, eine gegebenenfalls substituierte Alkoxygruppe oder ein Halogenatom sind, R³ und R⁴ Wasserstoff oder Methyl sind, n eine positive ganze Zahl von 1 bis 4 ist, m und k jeweils eine positive ganze Zahl von 1 bis 5 sind, p, q, r positive Zahlen sind, wobei das Polymer ein gewichtsmittleres Molekulargewicht von 1.000 bis 500.000 aufweist,
einen Photosäurebildner, der in der Lage ist, bei Aussetzen gegenüber Hochenergiestrahlung eine Säure zu bilden, und
einen Vernetzer, der in der Lage ist, mithilfe der vom Photosäurebildner gebildeten Säure eine Vernetzung des Polymers zu bewirken.

2. Verfahren nach Anspruch 1, wobei das Substrat eine Rohling zur Herstellung einer Photomaske ist.

3. Verfahren nach Anspruch 1 oder 2, wobei die Hochenergiestrahlung Elektronenstrahlen umfasst.

4. Verfahren nach einem der Ansprüche 1 bis 3, wobei die Negativresistzusammensetzung als chemisch verstärkte Negativresistzusammensetzung formuliert ist, die weiters (A) eine basische Verbindung, (B) ein Tensid und (C) ein organisches Lösungsmittel umfasst.

5. Verfahren nach einem der Ansprüche 1 bis 4, wobei X eine Gruppe ist, die aus Methyl, tert-Butyl, Methoxy und tert-Butoxy ausgewählt ist.

6. Verfahren nach einem der Ansprüche 1 bis 5, wobei die folgenden Ungleichungen erfüllt sind:
0 < r/(p+q+r)≤ 0,3
0 < q/(p+q+r) ≤ 0,15.

7. Verfahren nach einem der Ansprüche 1 bis 6, wobei R¹ und R² jeweils unabhängig voneinander Folgendes sind: eine aus Methyl, Ethyl, Propyl, Isopropyl, n-Butyl, Isobutyl und tert-Butyl ausgewählte Alkylgruppe; oder eine aus Methoxy, Ethoxy, Propoxy, n-Butoxy, Isobutoxy und tert-Butoxy ausgewählte Alkoxygruppe, die gegebenenfalls mit einer aus einer Epoxygruppe, einer Hydroxygruppe und einem Halogenatom ausgewählten Gruppe substituiert ist.

## Revendications

1. Procédé pour former un motif de réserve, comprenant les étapes consistant à :
appliquer une composition de réserve négative sur un film en chrome ou en un composé du chrome déposé sur un substrat par pulvérisation cathodique, pour former un revêtement,
traiter le revêtement à la chaleur et exposer le revêtement à un rayonnement de forte énergie,
éventuellement traiter le revêtement exposé à la chaleur, et développer le revêtement avec un révélateur,
ladite composition de réserve négative comprenant
un polymère comprenant des motifs récurrents de formule générale (1) : 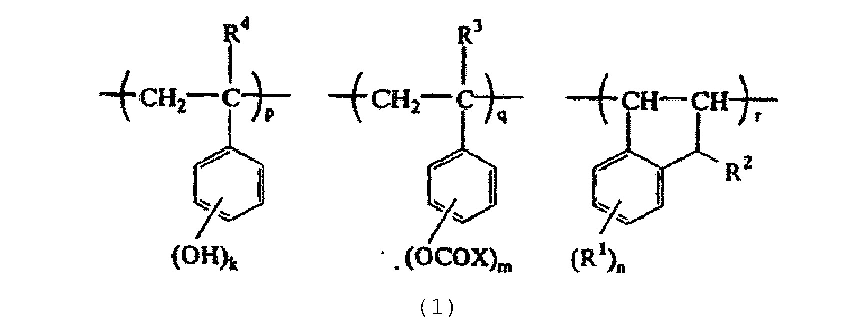 dans laquelle X est un groupe alkyle linéaire ou ramifié ayant de 1 à 4 atomes de carbone ou un groupe alcoxy linéaire ou ramifié ayant de 1 à 4 atomes de carbone, chacun de R¹ et R² est indépendamment un atome d'hydrogène, un groupe hydroxy, un groupe alkyle linéaire ou ramifié, un groupe alcoxy éventuellement substitué, ou un atome d'halogène, R³ et R⁴ sont l'hydrogène ou méthyle, n est un entier positif de 1 à 4, chacun de m et k est un entier positif de 1 à 5, p, q, r sont des nombres positifs, le polymère ayant une masse moléculaire moyenne en masse de 1 000 à 500 000,
un générateur de photoacide capable de générer un acide lors d'une exposition à un rayonnement de forte énergie, et
un agent de réticulation capable d'induire une réticulation du polymère à l'aide de l'acide généré par le générateur de photoacide.

2. Procédé selon la revendication 1, dans lequel ledit substrat est une découpe formant un masque photographique.

3. Procédé selon la revendication 1 ou 2, dans lequel le rayonnement de forte énergie comprend un faisceau d'électrons.

4. Procédé selon l'une quelconque des revendications 1 à 3, dans lequel la composition de réserve négative est formulée comme une composition de réserve négative chimiquement amplifiée comprenant en outre (A) un composé basique, (B) un tensioactif, et (C) un solvant organique.

5. Procédé selon l'une quelconque des revendications 1 à 4, dans lequel X est un groupe choisi parmi méthyle, tert-butyle, méthoxy et tert-butoxy.

6. Procédé selon l'une quelconque des revendications 1 à 5, dans lequel les inégalités suivantes sont satisfaites :
0 < r/(p+q+r) ≤ 0,3
0 < q/(p+q+r) ≤ 0,15

7. Procédé selon l'une quelconque des revendications 1 à 6, dans lequel chacun de R¹ et R² est indépendamment un groupe alkyle choisi parmi méthyle, éthyle, propyle, isopropyle, n-butyle, isobutyle, et tert-butyle ; ou un groupe alcoxy choisi parmi méthoxy, éthoxy, propoxy, n-butoxy, isobutoxy et tert-butoxy, qui est éventuellement substitué par un groupe choisi parmi un groupe époxy ; un groupe hydroxy ; ou un atome d'halogène.
